# EUROPEAN PATENT APPLICATION

(11) **EP 4 807 958 A1**
(43) Date of publication of application: **16.09.2026**
(21) Application number: 25163774.0
(22) Date of filing: 14.03.2025
(51) Int. Cl.: H02M 1/00, H02M 1/12, H02M 7/483, H02M 7/487, H02M 7/5387

(54) **METHOD AND CONTROLLER FOR CONTROLLING FILTER CELL, AND ELECTRIC POWER CONVERTER SYSTEM**

(71) Applicant: ABB SCHWEIZ AG, 5400 Baden (CH)
(72) Inventor: Mattsson, Valtteri, 00380 Helsinki (FI); Vetterli, Manuel, 4053 Basel (CH); Abrach, Stefan, 8636 Wald (CH)
(74) Representative: Kolster Oy Ab

(57) **Abstract**

A method and a controller for controlling a filter cell comprising a DC intermediate circuit (Cf), an input (IN) of the filter (10) cell being coupled to a phase output (AC) of a phase leg (21) of an inverter (20) and the filter cell being configured to be controllable to connect the input of the filter cell to an output of the filter cell via the DC intermediate circuit (Cf) and to alternatively connect the input of the filter cell to the output of the filter cell such that the DC intermediate circuit is bypassed, wherein the filter cell (10) is controlled to connect the input of the filter cell to the output of the filter cell such that the DC intermediate circuit (Cf) is bypassed in response to an absolute value of a reference signal of the phase leg (21) of the inverter (20) being within a predetermined range.

## Description

### TECHNICAL FIELD

The present invention relates to a method and a controller for controlling a filter cell and to an electric power converter system.

### BACKGROUND

An electric power converter system may comprise an inverter with at least one phase and at least one filter cell for each phase of the inverter coupled to a phase output of a phase leg of the inverter. The inverter may be implemented by a two-level converter circuit or a multi (three or more) -level converter circuit, such as a neutral-point clamped (NPC) or an active neutral-point clamped (ANPC) converter circuit, for example, which may also be capable of operating as a rectifier. The filter cell(s) may be implemented as active filter cell(s), AFC, comprising a DC intermediate circuit, such that the filter cell is capable of connecting the input of the filter cell to an output of the filter cell via the DC intermediate circuit and to alternatively connect the input of the filter cell to the output of the filter cell such that the DC intermediate circuit is bypassed. An example of such a system is disclosed in US 5805437. The filter cell(s) may also be implemented as floating cell(s) such that the cell does not have its own power supply means as disclosed in US 2003/0026111 A1.

The control of the filter cell(s) may be implemented in various ways and may be based on at least a voltage reference for the inverter or the electric power converter system. The pulse-width modulation (PWM) or another modulation technique may be used in the control. Moreover, the control of the inverter and filter cell(s) may be implemented by a single control entity by assuming that the complete electric power converter system is regarded as a multilevel converter, for instance. It is also possible to control the filter cell(s) separately based on an error between the voltage reference of the inverter and the output voltage of the inverter, for example. The control of filter cell(s) may aim at reducing an error in the voltage produced by the electric power converter system with respect to the voltage reference for the inverter or the electric power converter system, for instance.

Generally, such a filter cell can enable to modify the output voltage provided by the inverter and the output voltage from the filter cell may thus better approximate a voltage reference for the inverter or the electric power converter system as the filter cell can generate additional voltage steps to the voltage steps generated by the inverter, for example. The smaller voltage steps in turn can be used for reducing e.g. harmonic distortion and consequently harmonic losses in an electric machine supplied by the electric power converter system. Generally, such filter cells may be used to optimize an inverter output filter size, cost and/or weight, as well as increase the power capability of the electric power converter system, for example.

A problem related to the use of such filter cell(s) is that the loading of the capacitor(s) of the DC intermediate circuit of the filter cell(s) may be high requiring respective dimensioning of the DC intermediate circuit and the capacitor(s) thereof. Consequently, the physical size of the filter cell(s) may become large and also the cost of the filter cell(s) may then become high.

### BRIEF DESCRIPTION

An object of the present invention is thus to provide a method and an apparatus for implementing the method so as to overcome the above problem or at least to alleviate the problem. The objects of the invention are achieved by a method, a computer program product and a controller which are characterized by what is stated in the independent claims. The preferred embodiments of the invention are disclosed in the dependent claims.

The invention is based on the idea of controlling the filter cell to connect the input of the filter cell to the output of the filter cell such that the DC intermediate circuit of the filter cell is bypassed in response to an absolute value of a reference signal of the phase leg of the inverter being within a predetermined range.

An advantage of the solution of the invention is that the loading of the DC intermediate circuit of the filter cell capacitor bank can be efficiently optimized and reduced.

### BRIEF DESCRIPTION OF THE DRAWINGS

In the following the invention will be described in greater detail by means of preferred embodiments with reference to the accompanying drawings, in which
Figure 1 illustrates an example diagram of an electric power converter system according to an embodiment;
Figure 2 illustrates an example diagram of an electric power converter system according to an embodiment;
Figure 3 illustrates an example diagram of voltages in an electric power converter system;
Figure 4 illustrates an example diagram of voltages in an electric power converter system;
Figure 5 illustrates an example diagram of voltages in an electric power converter system according to an embodiment;
Figure 6 illustrates an example diagram of voltages in an electric power converter system according to an embodiment;
Figure 7 illustrates an example diagram of voltages in an electric power converter system according to an embodiment;
Figure 8 illustrates an example diagram of voltages in an electric power converter system according to an embodiment; and
Figure 9 illustrates an example diagram of output current total harmonic distortion of an electric power converter system according to embodiments.

### DETAILED DESCRIPTION

The following embodiments are exemplary. Embodiments described herein may be implemented in various manners other than the ones described below. Although the description may refer to "an", "one", or "some" embodiment(s) in several locations, this does not necessarily mean that each such reference is to the same embodiment(s), or that the feature only applies to a single embodiment, for example. Single features of different embodiments may also be combined to provide other embodiments. When a particular feature, structure, or characteristic is described in connection with an embodiment, it is submitted that it is within the knowledge of one skilled in the art to affect such feature, structure, or characteristic in connection with other embodiments whether or not explicitly described.

Furthermore, e.g. terms "comprises", "comprising", "has", "having", "includes" and/or "including" should be understood as not limiting the described embodiments to consist of only those features, elements, components and/ or combinations thereof that have been mentioned, and such embodiments may also contain features, elements, components and/ or combinations thereof that have not been specifically mentioned. Reference numbers, in the description and/or in the claims, serve to illustrate the embodiments with reference to the drawings, without limiting the embodiments to these examples only. Generally, all terms and expressions used should be interpreted broadly and they are intended to illustrate, not to restrict, the embodiments. The figures only show components necessary for understanding the various embodiments. The number, shape and/or configuration of the various elements, and generally their implementation, could vary from the examples shown in the figures.

Moreover, it should be understood that although terms "first," "second" and the like may be used herein to describe various elements, these elements should not be limited by these terms. Such terms are only used to distinguish one element from another. For example, a first element could be termed a second element, and similarly, a second element could be termed a first element, without departing from the scope of example embodiments. As used herein, expression "and/or" includes any and all combinations of one or more of the listed terms.

The application of the embodiments described herein is not, unless otherwise stated, restricted to any specific system, but they may be applied in various electric power converter systems. In addition, the use of the embodiments described herein is not restricted to any system utilizing a specific basic frequency or to any specific voltage level, for example.

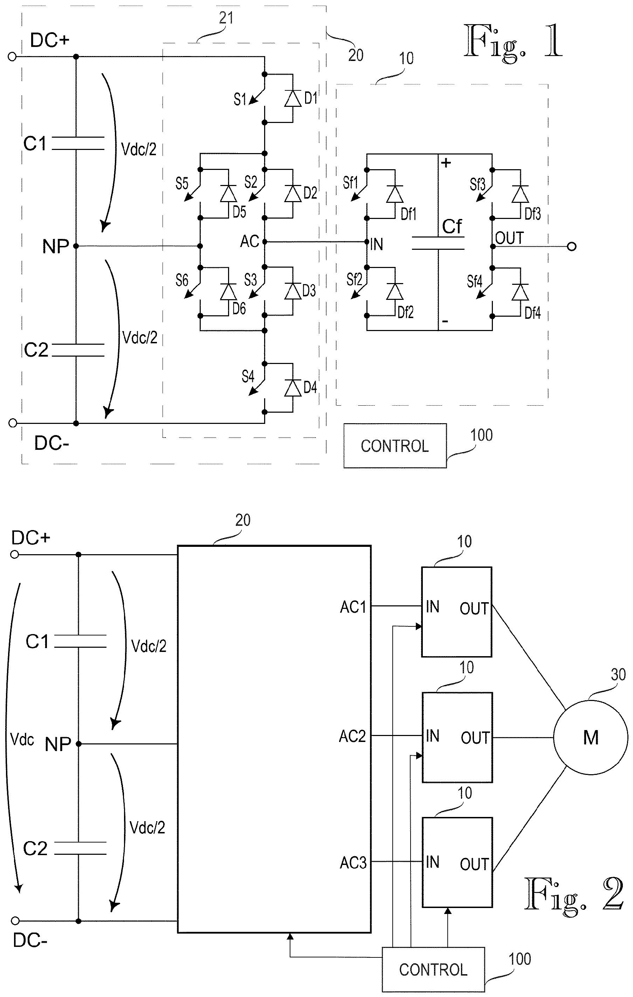

Figure 1 shows an example diagram of an electric power converter system according to an embodiment. It should be noted that the figure only presents elements essential to the understanding of the invention. The example system shows a single phase leg (a switching leg or branch) 21 of a multi-level electric power converter 20, which in this example is a three-level (3L) active neutral point clamped, ANPC, converter 20. The converter 20 could, however, also be a two-level converter or another kind of multi-level converter, such as a neutral point clamped, NPC, converter, for instance, and the number of levels could also be more than three. The converter 20 could be a medium voltage or high voltage converter, for example, and configured to operate at nominal voltage levels of at least 1 kV or more, e.g. at nominal voltage levels of several kV. The illustrated phase leg 21 may be one phase leg of a multi-phase converter, such as a three-phase converter, in which case the converter 20 comprises a respective number of the phase legs 21. The illustrated phase leg 21 could also be a phase leg of a one-phase converter, for example. The converter 20 may operate at least as an inverter, i.e. as a DC-to-AC converter. Term 'inverter' herein thus generally refers to an electronic device or circuitry that is able to convert direct current (DC) and voltage to alternating current (AC) and voltage. The converter 20 may also be configured to operate as a rectifier, i.e. as an AC-to-DC converter. The converter 20 could be part of a frequency converter further comprising a rectifier (not shown in the figures) or obtain a DC supply from a suitable DC power source, for example. The example of Figure 1 further shows a DC (voltage) intermediate circuit (DC link) of or for the converter 20 represented by capacitances C1 and C2 connected between the positive direct current pole DC+, the negative direct current pole DC-, and the neutral direct current pole NP. In the example, a voltage between the positive direct current pole DC+ and the neutral direct current pole NP is Vdc/2 and a voltage between the neutral direct current pole NP and the negative direct current pole DC is also Vdc/2 and hence the voltage over the DC intermediate circuit, or DC link voltage, is Vdc. The structure of the intermediate circuit could also be different, depending on the circuit configuration used. The DC intermediate circuit C1, C2 could be part of the converter 20 or at least partly external to the converter 20.

The phase leg 21 comprises a phase output, i.e. an alternating current pole AC, a positive direct current pole DC+, a negative direct current pole DC-, and a neutral direct current pole NP. Further, the phase leg 21 comprises a first controllable semiconductor switch S1 and a second controllable semiconductor switch S2 connected in series between the positive direct current pole DC+ and the alternating current pole AC of the phase leg 21. A first antiparallel diode D1 is connected in parallel to the first controllable semiconductor switch S1 and a second antiparallel diode D2 is connected in parallel to the second controllable semiconductor switch S2. Further, the phase leg 21 comprises a third controllable semiconductor switch S3 and a fourth controllable semiconductor switch S4 connected in series between the negative direct current pole DC- and the alternating current pole AC of the phase leg 21. A third antiparallel diode D3 is connected in parallel to the third controllable semiconductor switch S3, and a fourth antiparallel diode D4 is connected in parallel to the fourth controllable semiconductor switch S4. Further, the phase leg 21 comprises a fifth controllable semiconductor switch S5 connected between the neutral direct current pole NP and a connection point between the first controllable semiconductor switch S1 and the second controllable semiconductor switch S2, and a sixth controllable semiconductor switch S6 connected between the neutral direct current pole NP and a connection point between the third controllable semiconductor switch S3 and the fourth controllable semiconductor switch S4. A fifth antiparallel diode D5 is connected in parallel to the fifth controllable semiconductor switch S5 and a sixth antiparallel diode D6 is connected in parallel to the sixth controllable semiconductor switch S6. The controllable semiconductor switches S1 to S6 can be IGBTs (Insulated Gate Bipolar Transistor) or FETs (Field-Effect Transistor) or any suitable controllable semiconductor switches, for example.

The example system of Figure 1 further shows a filter cell 10, an input IN of which is coupled to the phase output AC of the phase leg 21 of the converter 20. There could be more than one such filter cells 10 connected in series. The filter cell 10 comprises a DC (voltage) intermediate circuit Cf. According to an embodiment, the DC intermediate circuit Cf comprises at least one capacitor. A voltage provided by the DC intermediate circuit Cf may be referred to as a cell voltage. According to an embodiment, the DC intermediate circuit Cf may comprise two or more capacitors connected in parallel and/or series with each other. The filter cell 10 is configured to be controllable to connect the input IN of the filter cell 10 to an output OUT of the filter cell 10 via the DC intermediate circuit Cf and to alternatively connect the input IN of the filter cell 10 to the output OUT of the filter cell 10 such that the DC intermediate circuit Cf is bypassed. For this, the filter cell 10 may comprise a plurality of controllable semiconductor switches which enable to connect the DC intermediate circuit Cf between the input IN of the filter cell 10 and the output OUT of the filter cell 10 and to alternatively bypass DC intermediate circuit Cf. In the example of Figure 1 the filter cell 10 comprises four controllable semiconductor switches such that a series connection of a first controllable semiconductor switch Sf1 and a second controllable semiconductor switch Sf2 (a first half bridge) is connected in parallel to the DC intermediate circuit Cf and a series connection of a third controllable semiconductor switch Sf3 and a fourth controllable semiconductor switch Sf4 (s second half-bridge) is connected in parallel to the DC intermediate circuit Cf. The connection point between the first controllable semiconductor switch Sf1 and the second controllable semiconductor switch Sf2 forms the input IN of the filter cell 10 and the connection point between the third controllable semiconductor switch Sf3 and the fourth controllable semiconductor switch Sf4 forms the output OUT of the filter cell 10. In the example the filter cell 10 further comprises four antiparallel diodes Df1, Df2, Df3, Df4 each connected in parallel to a respective controllable semiconductor switch Sf1, Sf2, Sf3, Sf4. The controllable semiconductor switches Sf1 to Sf4 can be IGBTs (Insulated Gate Bipolar Transistor) or FETs (Field-Effect Transistor) or any suitable controllable semiconductor switches, for example. Thus, in the example of Figure 1 the filter cell 10 essentially comprises an H-bridge formed by the four controllable semiconductor switches Sf1, Sf2, Sf3, Sf4 which H-bridge has its own DC intermediate circuit Cf. It should be noted that the number of the controllable semiconductor switches as well as their configuration in the filter cell 10 could vary from the example shown in Figure 1. The filter cell 10 may thus constitute an active filter. Moreover, the filter cell 10 in the example of Figure 1 is a floating filter cell as it does not have any separate power supply of its own.

The filter cell 10 is thus at least configured to be controllable to connect the input IN of the filter cell 10 to an output OUT of the filter cell 10 via the DC intermediate circuit Cf and to alternatively connect the input IN of the filter cell 10 to the output OUT of the filter cell 10 such that the DC intermediate circuit Cf is bypassed. Moreover, according to an embodiment, the filter cell 10 may be configured to be controllable to connect the input IN of the filter cell 10 to the output OUT of the filter cell 10 via the DC intermediate circuit Cf in a first direction of the DC intermediate circuit Cf and to alternatively connect the input IN of the filter cell 10 to the output OUT of the filter cell 10 via the DC intermediate circuit Cf in a second direction of the DC intermediate circuit Cf, wherein the second direction is opposite to the first direction. Consequently, the filter cell 10 may thus have at least three alternative (main) switching states. In a first (main) switching state (a zero vector), the filter cell 10 may directly connect the input IN of the filter cell 10 to the output OUT of the filter cell 10 thus bypassing the DC intermediate circuit Cf. For this, in the example circuit of Figure 1 there may be two alternative sub-switching states: only both upper switches Sf1 and Sf3 are switched on (conducting state) or only both lower switches Sf2 and Sf4 are switched on. In normal operation of the filter cell 10, these two alternative sub-switching states may be suitably alternated in the switching cycle. In a second (main) switching state, the converter cell 10 connects the input IN of the filter cell 10 to the output OUT of the filter cell 10 via the DC intermediate circuit Cf in a first direction of the DC intermediate circuit Cf, i.e. connects the DC intermediate circuit Cf between the input IN of the filter cell 10 and the output OUT of the filter cell 10 such that the voltage of the DC intermediate circuit Cf (a positive cell voltage) is added to the voltage provided from the alternating current pole AC of the phase leg 21. In a third (main) switching state, the filter cell 10 connects the input IN of the filter cell 10 to the output OUT of the filter cell 10 via the DC intermediate circuit Cf in a second direction of the DC intermediate circuit Cf, i.e. connects the DC intermediate circuit Cf between the input IN of the filter cell 10 and the output OUT of the filter cell 10 such that the voltage of the DC intermediate circuit Cf (a positive cell voltage) is subtracted from the voltage provided from the alternating current pole AC of the phase leg 21. In such a way, the voltage provided from the alternating current pole AC of the phase leg 21, which may be shaped like a step-function due to the finite number of voltage levels in the converter 20, may be suitably modified by the filter cell 10, e.g. further converted into a voltage, i.e. the output voltage at the output OUT of the filter cell 10, which may better approximate a voltage reference of the converter 20, when operating as an inverter, or the electric power converter system. The filter cell 10 could further have one or more additional switching states, which could be used for e.g. pre-charging the DC intermediate circuit Cf and/or for protective measures in fault situations.

Figure 1 further shows a control arrangement (device, apparatus system) 100 by or via which the controllable semiconductor switches S1 to S6 of the converter 20 and the controllable semiconductor switches Sf1 to Sf4 of the filter cell 10 can be controlled. For the sake of clarity, any control connections are not shown in Figure 1. The control of the controllable semiconductor switches S1 to S6 and Sf1 to Sf4 can involve one or more additional control elements and/or entities (not shown) depending on how the control is implemented, for example. At least part of the functionality of the embodiments described herein could be implemented in or by such a control arrangement 100.

Figure 2 shows another example diagram of an electric power converter system according to an embodiment. The example in Figure 2 comprises a three-phase electric power converter 20, which may comprise three respective phase legs 21 connected in parallel to the DC intermediate circuit (DC link) C1, C2, i.e. the DC intermediate circuit (DC link) C1, C2 is connected to the (at least two) DC poles DC+, DC-, NP of the electric power converter 20, and which electric power converter 20 is configured to operate at least as an inverter. The example in Figure 2 further comprises a respective filter cell for each of the three alternating current poles AC1, AC2, AC3 of the three-phase converter 20. The example in Figure 2 further comprises an electric machine 30 connected to the three alternating current poles AC1, AC2, AC3 of the three-phase converter 20. The electric machine 30 may be an electric motor, such as an induction motor. The electric power converter 20 may thus be configured to drive an electric motor 30. Instead of the electric machine 30, there could be another kind of load connected to the electric power converter 20. Moreover, there could further be passive output filters (not shown in the figure) connected in series with each of the active filter cells 10. Such passive filter could be comprised of passive components such as resistors, inductors, and/or capacitors, for example. An example of a passive filter is an LCR filter.

The normal control of the filter cell(s) 10 may be implemented in various ways and may be based on a reference, such as a voltage reference, for the converter 20 operating as an inverter or for the electric power converter system. Moreover, the control of the converter 20 and the filter cell(s) 10 may be implemented by a single control entity by assuming that the complete electric power converter system is regarded as a multilevel converter, for instance. It is also possible to control the filter cell(s) 10 separately based on an error between the voltage reference of the inverter and the output voltage of the converter 20 operating as an inverter, for example. The control of filter cell(s) 10 may generally aim at reducing an error in the output, e.g. in the voltage, produced by the electric power converter system with respect to the reference for the converter 20 operating as an inverter or for the electric power converter system, for instance. The application of the embodiments described herein is not limited to any specific control/modulation scheme and e.g. any known control/modulation scheme for the filter cell(s) 10 may be used. According to an embodiment, the filter cell(s) 10 could be controlled (operated) in accordance with a PWM modulation (also known as pulse-duration modulation, PDM, or pulse-length modulation, PLM) scheme, such as the carrier-based pulse width modulation, CBPWM, (e.g. sinusoidal pulse width modulation, SPWM) or the space vector pulse width modulation, SVPWM, or a model predictive pulse pattern control, MP3C, such as the OPP (optimal pulse patterns) -based MP3C modulation scheme or the carrier-based MP3C modulation scheme, in any known manner, for example.

An example of the PWM modulation scheme is a conventional real-time carrier-based pulse width modulation for the converter 20 (e.g. a 3L(A)NPC converter) and for the filter cell(s) of the converter. An error signal derived from a difference of the converter 20 switching state and the sinusoidal voltage reference may be fed to a PWM modulator for the filter cell(s). A balancing signal may be added on top to stabilize the filter cell(s). An example of the PWM modulation scheme is disclosed in US 6009002 A. Another example of controlling floating cells is disclosed in WO2018/029303. In US 2003/0026111 A1 floating converter cells without rectifier circuits are disclosed and a model predictive type controller is used to control both the main inverter and the floating converter cells in a single control stage. Further examples of known control/modulation schemes, such as the model predictive pulse pattern control, MP3C, scheme are disclosed e.g. in EP 4304073 A1, EP 4451530 A1, EP 4485773 A1 and in the documents cited therein, for instance.

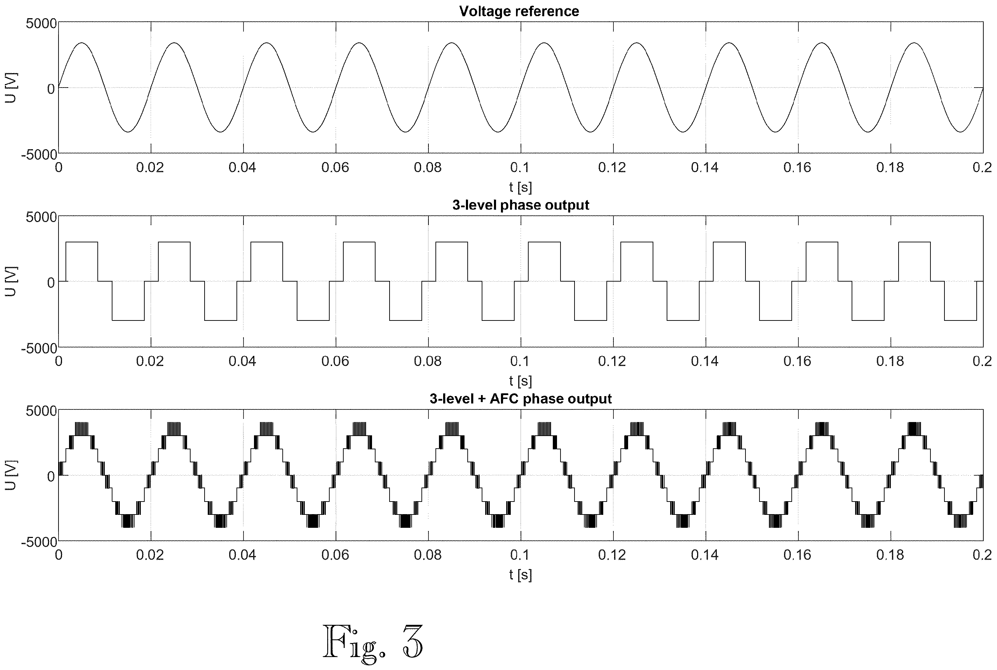

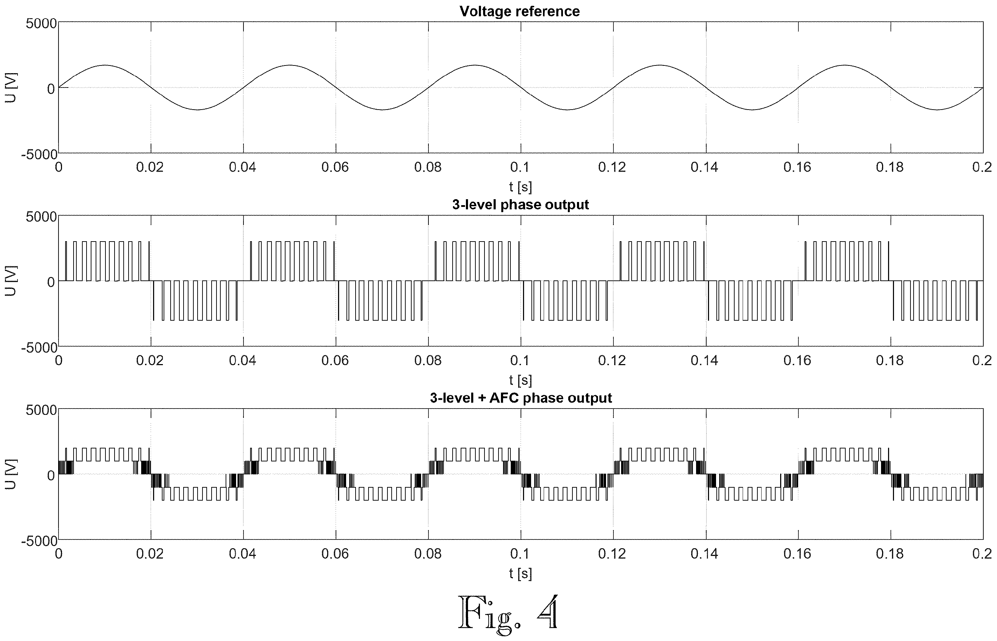

Figures 3 and 4 show examples of basic single phase switching voltage waveforms of the 3-level inverter output against neutral. In both Figures 3 and 4, the uppermost waveforms represent a voltage reference signal (an actual value) of (for) a phase leg 21 of the inverter 20. The middlemost waveforms represent the output voltage provided from the alternating current pole AC of the phase leg 21. And the lowermost waveforms represent the output voltage provided from the output OUT of the active filter cell, AFC, 10. In the example of Figure 3, an output voltage of 2400Vrms (phase-neutral), 4160Vrms (phase-phase) with a frequency of 50Hz has been shown. In the example of Figure 4, an output voltage of 1200Vrms (phase-neutral), with a frequency of 25Hz has been shown. In Figure 4, in the lower switching waveforms, two switching carrier frequencies are visible, the 3-level inverter 20 is switching slower with a frequency of 500Hz and the filter cell 10 faster with a 1500Hz carrier frequency. The 3-level inverter 20 switching is better visible, when the sinusoidal voltage reference is between 1000V and 2000V (1/3 ... 2/3 of Vdc/2). In example Figures 3 and 4, the voltage levels correspond to a 4kV medium voltage converter. The 3-level inverter is working with a DC link voltage of 6000V and Vdc/2 is thus 3000V. The cell voltage is 1/3 of Vdc/2 i.e. 1000V. These figures generally illustrate how the filter cell 10 in its normal operation can be used to modify the output voltage of the inverter 20 such that the resulting output voltage from the filter cell 10 better approximates the voltage reference signal.

According to an embodiment, a method for controlling a filter cell 10 is provided, wherein the filter cell 10 comprises a DC intermediate circuit Cf, wherein an input IN of the filter cell 10 is coupled to a phase output AC of a phase leg 21 of an inverter 20 and wherein the filter cell 10 is configured to be controllable to connect the input IN of the filter cell 10 to an output OUT of the filter cell via the DC intermediate circuit Cf and to alternatively connect the input IN of the filter cell 10 to the output OUT of the filter cell such that the DC intermediate circuit Cf is bypassed. The method comprises monitoring a reference signal of the phase leg 21 of the inverter 20 and controlling the filter cell 10 to connect the input IN of the filter cell 10 to the output OUT of the filter cell such that the DC intermediate circuit Cf is bypassed in response to an absolute value (modulus, magnitude) of the reference signal of the phase leg 21 of the inverter 20 being within a predetermined range. According to an embodiment, the reference signal of the phase leg of the inverter is sinusoidal. According to an embodiment, the reference signal for the modulation of the phase leg of the inverter is a voltage reference signal of the phase leg of the inverter. According to an embodiment, the method comprises modifying an output voltage from the phase output AC of the phase leg 21 of the inverter 20 by the filter cell 10 on the basis of the reference signal of the phase leg 21 of the inverter 20 when the absolute value of the reference signal of the phase leg of the inverter is outside the predetermined range. In other words, when the absolute value of the reference signal of the phase leg of the inverter is outside the predetermined range, the filter cell 10 may be operated in a normal manner e.g. according to any known control/modulation scheme.

Generally, the reference signal, i.e. a control signal or a switching reference signal, such as a voltage reference signal, of the phase leg 21 of the inverter 20 may refer to any reference signal based on which the output of the respective phase leg 21 of the inverter 20 is controlled. Such a reference signal, such as a voltage reference signal, may be e.g. a reference signal used as a basis for the modulation, e.g. a reference signal for the modulation, in the control of the controllable semiconductor switches of the respective phase leg 21 of the inverter 20 in order to generate the desired output of the phase leg 21 of the inverter 20. Such a reference signal, such as a voltage reference signal, which may be essentially sinusoidal, may be readily available in the control system of the inverter 20 and hence can be directly monitored. Such monitoring may comprise e.g. receiving the reference signal in the control arrangement 100 from another entity if such reference signal is not readily available in the control arrangement itself, for instance. The reference signal may also be equivalently obtained or constructed from one or more other signals and/or otherwise indirectly monitored via one or more other signals indicative of the reference signal e.g. depending on the particular control/modulation scheme used for the control of the inverter 20. Such a reference signal, such as a voltage reference signal, could be provided by e.g. an outer control loop of the control of the inverter 20. Moreover, in case the inverter is a multiphase inverter, a respective phase-specific reference signal of the respective phase leg 21 of the inverter 20 is used for controlling each one of the phase specific filter cells 10.

The reference signal may indicate an actual value of the reference quantity, or the reference signal may indicate a relative value, such as a per unit (p.u.) value, of the reference quantity, for example. The relative value, or the per unit (p.u.) value, of the reference quantity may be defined as an actual value of the reference quantity divided by a base value of the reference quantity. As an example, if the reference signal is a voltage reference signal, it may be or generally indicate a reference value for the voltage in terms of an actual value of the voltage. For example, the voltage reference signal shown in the examples of Figures 3 to 8 indicates the reference value for the voltage in terms of the actual value of the voltage reference. Alternatively, a voltage reference signal may be or generally indicate the reference value for the voltage in terms of a relative, or per unit, value of the voltage, for instance. An example of such a relative value, or a per unit value, is a modulation index. According to an embodiment, the modulation index m may be defined as: $m = \frac{Vref}{Vdc / 2}$ where
*Vref* is an actual value of the voltage reference, and
*Vdc* is the voltage over the DC intermediate circuit, or DC link (DC bus) voltage.

Thus, the voltage reference signal could be a reference signal indicating the actual value Vref of the voltage reference or a reference signal indicating a relative value of the voltage, or a per unit value of the voltage, such as the modulation index m. However, the voltage reference signal is not limited to these examples.

Due to possible overmodulation schemes, for example, the modulation index m can exceed unity (1). As an example, a typical maximal modulation index value with 3^{rd} harmonic injection schemes may be in a range of about 1.15. Some modulation schemes may allow even higher values for the modulation index. A region wherein the modulation index m is less than or equal to 1.0 may be referred to as a linear range or linear modulation range. Term overmodulation thus generally refers to operation outside of the linear (modulation) range of the inverter.

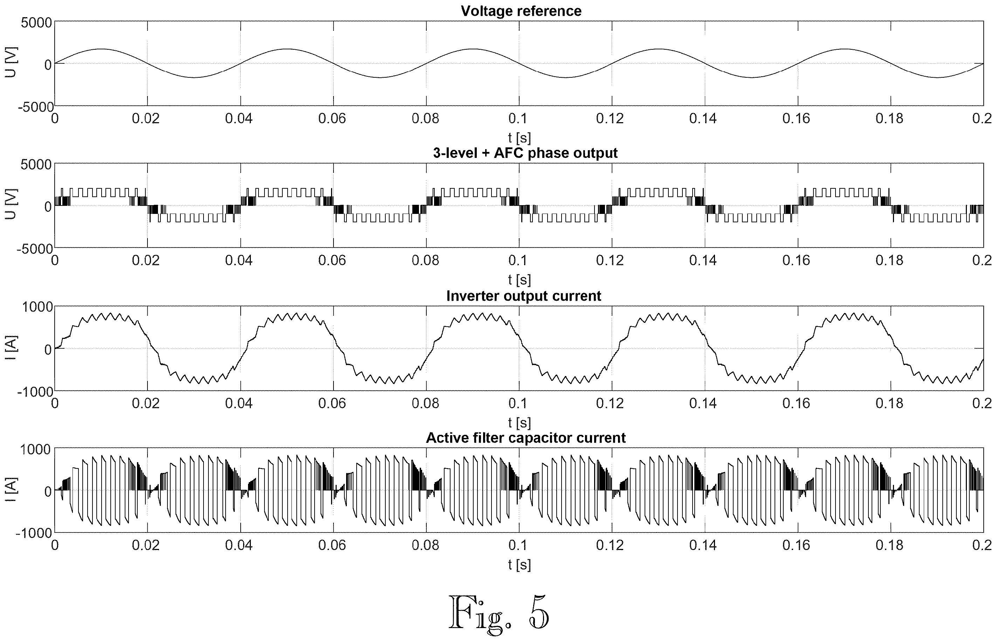

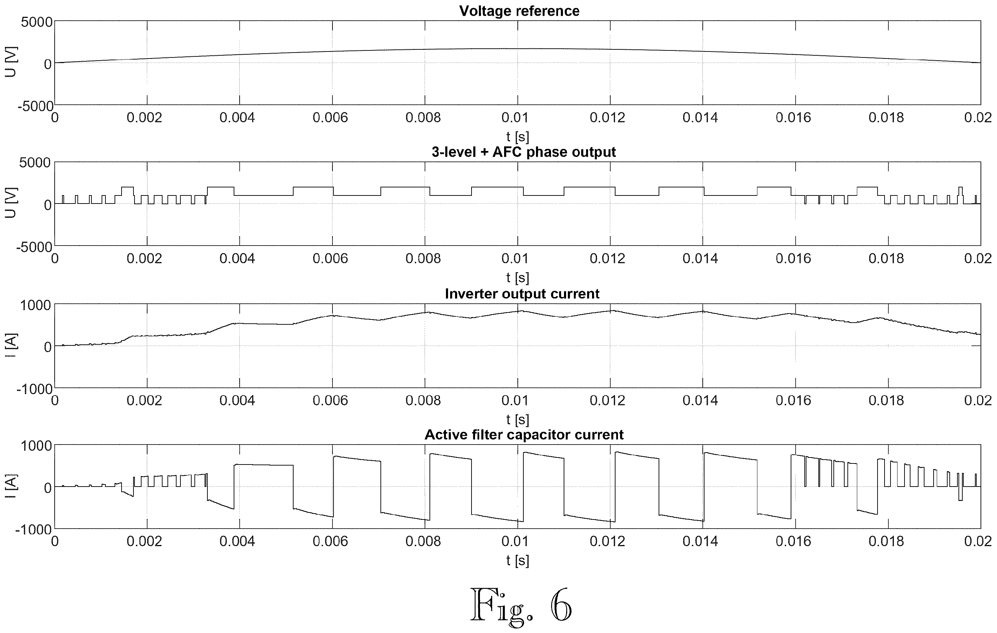

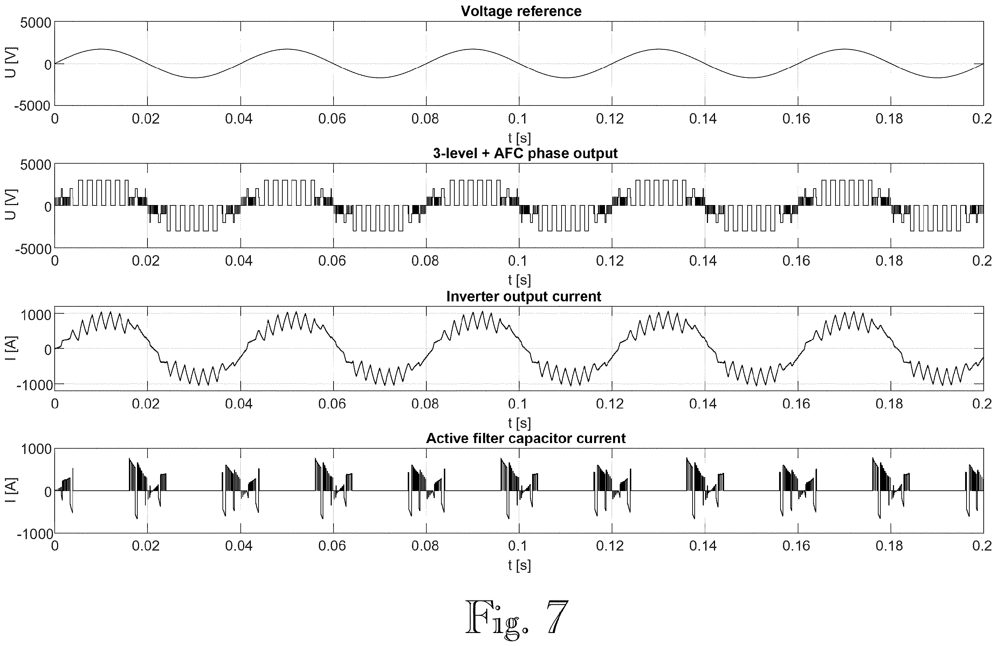

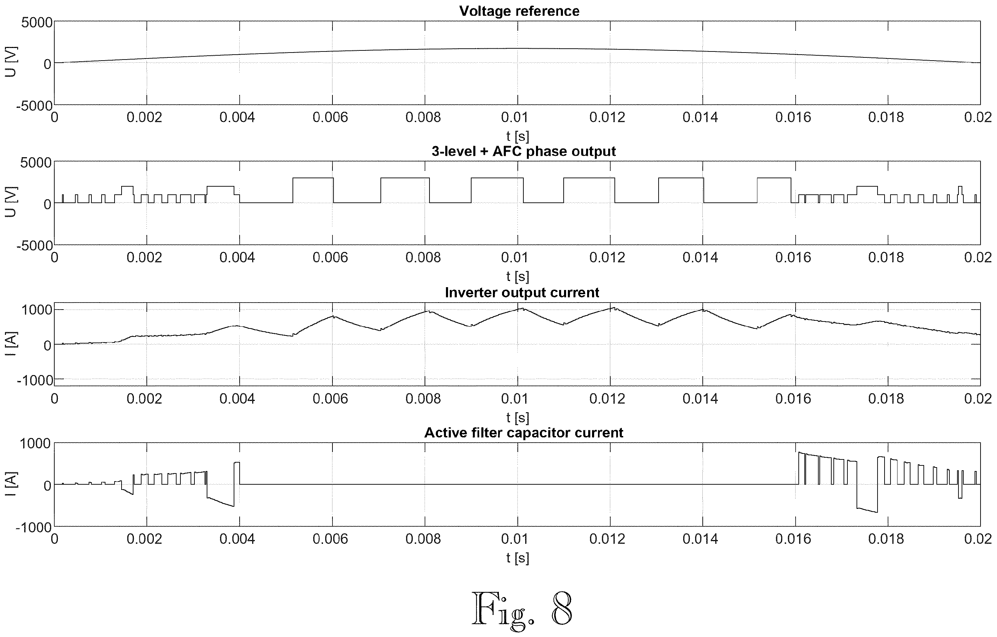

Figures 5, 6, 7 and 8 show examples of voltage and current waveforms in the 3-level inverter 20 when an output voltage of the inverter 20 is 1200Vrms (phase-neutral) with a frequency of 25Hz. Figure 5 illustrates an example in which the filter cell 10 is controlled in a normal manner. The uppermost waveform shows the voltage reference signal (an actual value) of the phase leg 21 of the inverter 20, the second waveform shows the corresponding output voltage provided from the output OUT of the active filter cell, AFC, 10, the third waveform shows the corresponding inverter 20 output current provided from the alternating current pole AC of the phase leg 21 and the lowermost waveform shows the corresponding current through the DC intermediate circuit Cf, i.e. through the capacitor(s) thereof, of the filter cell 10. Figure 6 shows enlarged a portion of Figure 5, namely time period between 0 and 0.02 s, i.e. corresponding to one (positive) half-cycle of the sinusoidal voltage reference signal. In the example of Figures 5 and 6, the current through the DC intermediate circuit Cf is 0.96 p.u. Figure 7 illustrates an example in which the filter cell 10 is controlled according to an embodiment such that the filter cell 10 is controlled to connect the input IN of the filter cell 10 to the output OUT of the filter cell such that the DC intermediate circuit Cf is bypassed in response to an absolute value of the voltage reference signal of the phase leg 21 of the inverter 20 being within a predetermined range. In the example of Figure 7 the predetermined range is 1/3V_{Max} - 2/3V_{Max} where V_{Max} is a maximum absolute value (i.e. a modulus or magnitude) for the voltage reference signal of the phase leg of the inverter without overmodulation. In terms of the modulation index m as defined above, V_{Max} may be expressed as 1. Thus, in the example, V_{Max} in terms of an actual value is equal to Vdc/2 = 3000V. The uppermost waveform shows the voltage reference signal (an actual value) of the phase leg 21 of the inverter 20, the second waveform shows the corresponding output voltage provided from the output OUT of the active filter cell, AFC, 10, the third waveform shows the corresponding inverter 20 output current provided from the alternating current pole AC of the phase leg 21 and the lowermost waveform shows the corresponding current through the DC intermediate circuit Cf, i.e. through the capacitor(s) thereof, of the filter cell 10. Figure 8 shows enlarged a portion of Figure 7, namely time period between 0 and 0.02 s, i.e. corresponding to one (positive) half-cycle of the sinusoidal voltage reference signal. Since the absolute value of the voltage reference signal, such as |Vref| or |m|, is used as a basis for controlling the bypassing of the DC intermediate circuit Cf of the filter cell, the DC intermediate circuit Cf may be essentially similarly bypassed during both the positive half-cycle and the negative half cycle of the sinusoidal voltage reference signal as exemplified in Figure 7. In the example of Figures 7 and 8, the current through the DC intermediate circuit Cf is 0.36 p.u., i.e. substantially lower than in the example of Figures 5 and 6. Thus, in Figures 7 and 8, when compared to Figures 5 and 6, the working principle of an optimization of the filter cell 10 control by bypassing the DC intermediate circuit Cf in response to the absolute value of the voltage reference signal of the phase leg 21 of the inverter 20 being within a predetermined range is visible. According to an embodiment, the optimization of the filter cell 10 control by such bypassing of the DC intermediate circuit Cf may have the best effect when the sinusoidal voltage reference of the respective phase leg 21 of the inverter 20 is in a range of 1/3V_{Max} - 2/3V_{Max}, where V_{Max} is the maximum absolute value for the voltage reference signal of the phase leg of the inverter without overmodulation. In the example, V_{Max} in terms of an actual value is equal to Vdc/2 = 3000V corresponding to value 1 in terms of the modulation index m. Thus, the control of the filter cell 10 may force the filter cell 10 switching reference to zero, i.e. to bypass the DC intermediate circuit Cf of the filter cell 10, when the e.g. sinusoidal switching reference of the respective phase leg 21 of the inverter 20 lies within a given band, i.e. within the predetermined range. According to an embodiment, the predetermined range can be defined symmetrically around the middle level (e.g. corresponding to m=0.5) of a sinusoidal reference signal, such as voltage reference signal, of the phase leg 21 of the inverter 20, and the width of the predetermined range then defines the current reduction effect. According to another embodiment, it is also possible to shift the predetermined range with respect to the to the middle level of the sinusoidal reference signal to account for a phase shift between the inverter 20 output voltage and current, for example.

According to an embodiment, the predetermined range R may be defined as: $X ∗ {V}_{Max} \leq R \leq \left(1-X\right) ∗ {V}_{Max} ,$ wherein
V_{Max} is a maximum absolute value for the voltage reference signal of the phase leg of the inverter
X is a selectable variable such that 0<X<0.5.

According to an embodiment, the maximum absolute value V_{Max} for the voltage reference signal of the phase leg of the inverter may be a predetermined value. As an example, it may indicate a maximum possible and/or maximum allowable absolute value for the voltage reference signal. According to an embodiment, the maximum absolute value V_{Max} for the voltage reference signal of the phase leg of the inverter may indicate the maximum absolute value that the voltage reference signal of the phase leg of the inverter may have without overmodulation, i.e. during operation in the linear modulation range of the inverter, which may correspond to value 1 in terms of the modulation index m, for example. According to an embodiment, the maximum absolute value V_{Max} for the voltage reference signal of the phase leg of the inverter expressed in terms of an actual value is |Vdc/2|, i.e. one half of the (absolute) value of the voltage Vdc of the DC (voltage) intermediate circuit of the converter 20 or for the converter 20.

X is a selectable variable for controlling the level or degree of reduction of the filter cell 10 intermediate circuit Cf loading. Setting X to 0.5 will result in a continuous operation of the filter cell 10 without intermediate circuit Cf current reduction. Setting X to 0 will result in blocking the filter cell 10 normal modulation completely. According to an embodiment, X may be between 0.3 and 0.35, and preferably 1/3. In particular, the best benefit of the control function may be achieved, when a current loading condition of the sine wave is high and a sinusoidal reference signal e.g. when expressed in terms of the modulation index m is in a range between 0.33 to 0.67. During AFC zero state, the load current is not flowing through the capacitor.

As above equation 1 may indicate an optimal filter cell 10 intermediate circuit Cf current optimization for a unity power factor operation, where the phase current and phase voltage have an equal phase, the control can also be further optimized by tracking an actual phase current in a non-unity power factor operation. This may be the case, e.g. while operating (driving) an induction machine with the electric power converter system. While equation 1 above is symmetrical for the rising and falling slopes of the sinusoidal signal, an additional correction factor could be applied only to one of the slopes. According to an embodiment, for an inductive power factor of the output of the inverter 20, the additional factor is applied to the first edge after the sinusoidal signal zero crossing. Consequently, according to an embodiment, the predetermined range R may be defined as: $\left(X+{C}_{pf}\right) ∗ {V}_{max} \leq R \leq \left(1-X\right) ∗ {V}_{Max} ,$ wherein
V_{Max} is the maximum absolute value for the voltage reference signal of the phase leg of the inverter
C_{pf} is a correction factor for a non-unity power factor
X is a selectable variable such that 0<X<0.5.

For a capacitive power factor, the same correction is applied to last edge before a sine wave zero crossing.

The correction factor C_{pf} may be calculated as a relative value. As an example, a 15 degrees lagging power factor (the current waveform is behind the voltage waveform) may result in a correction factor C_{pf} = 15°/360°=~0.04. Depending on the optimization target, for example, the correction factor may also be higher or lower than the example. The correction factor C_{pf} may be limited by (*X + C_{pf}*) ≤ (*1 - X*).

The above approach may be effective, while the modulation index m of the inverter 20 remains below (1 *- X*) * *V_{Max}.* When the modulation index m is increased above the predetermined range, filter cell 10 pulsing is applied near the peak value of the output current. By applying an additional correction factor at higher modulation indexes, i.e. above (1 - *X*) * *V_{Max}*, the filter cell 10 intermediate circuit Cf current can be effectively controlled, while essentially maintaining a maximum modulation index range around the zero crossing of the sinusoidal signal. Consequently, according to an embodiment, the predetermined range R may be defined as: $X ∗ {V}_{Max} \leq R \leq \left(1-X+{C}_{peak}\right) ∗ {V}_{Max} ,$ wherein
V_{Max} is the maximum absolute value for the voltage reference signal of the phase leg of the inverter
Cₚₑₐₖ is a correction factor for a high modulation index
X is a selectable variable such that 0<X<0.5.

The correction factor Cₚₑₐₖ can be selected freely, however, when exceeding the maximal modulation index, adding further correction factor will not anymore have effect.

The two optional additional correction factors described above may allow a more precise modification of the modulation block range to adapt for different modulation indexes and/or power factors. As an end result, the filter cell 10 intermediate circuit Cf current can be better maintained at a desired level, but the negative effects of output current THD can be minimized. According to an embodiment, both correction factors may be applied simultaneously. Consequently, according to an embodiment, the predetermined range R may be defined as: $\left(X+{C}_{pf}\right) ∗ {V}_{Max} \leq R \leq \left(1-X+{C}_{peak}\right) ∗ {V}_{Max}$ wherein
V_{Max} is the maximum absolute value for the voltage reference signal of the phase leg of the inverter
C_{pf} is the correction factor for the non-unity power factor
Cₚₑₐₖ is the correction factor for the modulation index
X is a selectable variable such that 0<X<0.5.

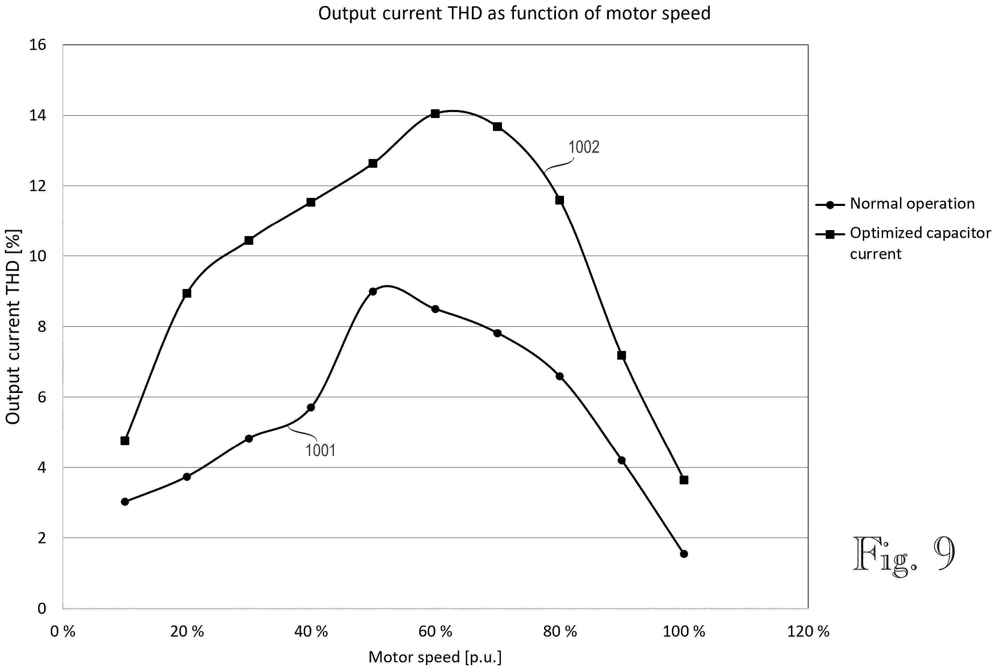

Figure 9 illustrates an example diagram of output current total harmonic distortion of an electric power converter system according to embodiments. In figure 9, curve 1001 shows an output current total harmonic distortion, THD, of the electric power converter system as a function of the motor 30 speed in a normal operation, when no optimization of the filter cell 10 control is performed. The respective filter cell 10 intermediate circuit Cf current reaches up to 96% p.u. of the nominal inverter 20 output current. Curve 1002 shows the output current total harmonic distortion, THD, of the electric power converter system as a function of the motor 30 speed when an optimization of the filter cell 10 control is performed according to an embodiment. The example illustrated by curve 1002 show a situation in which the optimization of the filter cell 10 control is used to limit the filter cell 10 intermediate circuit Cf current to below 60% p.u. levels. As a result of the optimization, the current THD is increased in the example, but it still remains in a typical level suitable for e.g. motors designed for frequency converter use.

As the dimensioning of the one or more capacitors of the cell 10 intermediate circuit Cf may be dependent on the maximal current requirement and the required current may be achieved e.g. by parallel connecting lower rated capacitors or capacitor elements, a direct reduction of the maximal required capacitor current can also lower the required amount of such parallel connected capacitors or capacitor elements. The example use case illustrated in Figure 9 will decrease the nominal current of a combined capacitor bank by about 37.5% (0.6p.u./0.96p.u.). This can lead to a reduction of physical capacitor elements by 37.5%, while the volume required by the capacitor elements is also reduced by 37.5%. At the same time also capacitor cost could be reduced by about 37.5%. Moreover, as the number of capacitors or capacitor elements can be reduced, also the total capacitance of the capacitor bank, i.e. the intermediate circuit Cf, can be reduced. As the capacitor bank voltage ripple may be dependent on the capacitor current, a reduction of capacitor current ripple will decrease the voltage ripple. Consequently, by combining the effects of a reduced capacitor bank capacitance and a lower current ripple loading, the combined effect may be that the capacitor bank, i.e. the intermediate circuit Cf, voltage ripple essentially does not increase. Generally, the invention according to the various embodiments described herein can be effectively used to optimize a footprint of such an active filter cell based converter solution or system.

According to an embodiment, a controller is provided for controlling a filter cell coupled to a phase output of a phase leg of an inverter, the controller being configured to carry out a method according to any one of the embodiments described herein.

According to an embodiment, an electric power converter system comprises an inverter with at least one phase and at least one filter cell for each phase of the inverter, an input of the filter cell being coupled to a phase output of a respective phase leg of the inverter, wherein the at least one filter cell comprises a DC intermediate circuit and wherein the at least one filter cell is configured to be controllable to connect the input of the filter cell to an output of the filter cell via the DC intermediate circuit and to alternatively connect the input of the filter cell to the output of the filter cell such that the DC intermediate circuit is bypassed. The electric power converter system further comprises control means configured to control the electric power converter arrangement, the control means comprising a controller for controlling a filter cell coupled to a phase output of a phase leg of an inverter, the controller being configured to carry out a method according to any one of the embodiments described herein.

The control arrangement 100 or other control means controlling the inverter 20 and the at least one filter cell 10 according to any one of the above embodiments, or a combination thereof, may be implemented as one unit or as two or more separate physical units that are configured to implement the functionality of the various embodiments. Herein the term 'unit' generally refers to a physical or logical entity, such as a physical device or a part thereof or a software routine.

Generally, the control arrangement 100 and/or any other means for implementing at least part of the functionality according to any one of the embodiments described herein may be implemented at least partly by means of one or more computers or corresponding digital signal processing (DSP) equipment provided with suitable software, for example. Such a computer or digital signal processing equipment preferably comprises at least a working memory (RAM) providing storage area for arithmetical operations, and a central processing unit (CPU), such as a general-purpose digital signal processor. The CPU may comprise a set of registers, an arithmetic logic unit, and a control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a suitable programming language, which may be a high-level programming language, such as C, Java, etc., or a low-level programming language, such as a machine language, or an assembler. The computer may also have an operating system which may provide system services to a computer program written with the program instructions. The computer or other apparatus implementing the various embodiments, or a part thereof, may further comprise suitable input means for receiving e.g. measurement and/or control data, and output means for outputting e.g. control or any other data. It is also possible to use a specific integrated circuit or circuits, such as application-specific integrated circuits (ASIC), digital signal processing devices (DSPD), programmable logic devices (PLD), field-programmable gate arrays (FPGA) and/or discrete electric components and devices for implementing the functionality according to any one of the embodiments.

The various embodiments described herein can be implemented in existing electric power converter systems and components thereof and/or by using separate dedicated elements or devices in a centralized or distributed manner. Present converter devices may comprise processors and memory, e.g. in a control arrangement of the converter device, that can be utilized in the functions according to the various embodiments described above. Generally, many electric devices, such as electric power systems, and components thereof, such as intelligent electronic devices, may comprise processors and memory that may also be utilized in implementing the functionality according to the various embodiments described herein. Thus, at least some or all modifications and configurations required for implementing an embodiment in existing converter devices may be performed as software routines, which may be implemented as added or updated software routines. If at least part of the functionality of any of the embodiments is implemented by software, such software may be provided as a computer program product comprising computer program code which, when run on a computer, causes the computer or corresponding arrangement to perform the functionality according to the embodiments as described herein. Such a computer program code may be stored or generally embodied on a computer readable medium, such as suitable memory, e.g. a flash memory or an optical memory, from which it is loadable to the unit or units executing the program code. In addition, such a computer program code implementing any of the embodiments may be loaded to the unit or units executing the computer program code via a suitable data network, for example, and it may replace or update a possibly existing program code. An embodiment may provide a computer program embodied on any client-readable distribution/data storage medium or memory unit(s) or article(s) of manufacture, comprising program instructions executable by one or more processors/computers, which instructions, when loaded into an apparatus, constitute the control arrangement, or any corresponding unit or an entity providing corresponding functionality, or at least part of the corresponding functionality. Programs, also called program products, including software routines, program snippets constituting "program libraries", applets and macros, can be stored in any medium and may be downloaded into an apparatus. In other words, each or some or one of the possible units/sub-units and/or algorithms for one or more functions/operations described above, for example by means of any of Figures 1 to 9 and any combination thereof, may be an element that comprises one or more arithmetic logic units, a number of special registers and control circuits.

It will be obvious to a person skilled in the art that, as the technology advances, the inventive concept can be implemented in various ways. The invention and its embodiments are not limited to the examples described above but may vary within the scope of the claims.

## Claims

1. A method for controlling a filter cell, wherein the filter cell comprises a DC intermediate circuit, wherein an input of the filter cell is coupled to a phase output of a phase leg of an inverter and wherein the filter cell is configured to be controllable to connect the input of the filter cell to an output of the filter cell via the DC intermediate circuit and to alternatively connect the input of the filter cell to the output of the filter cell such that the DC intermediate circuit is bypassed, the method comprising:
monitoring a reference signal of the phase leg of the inverter; and
controlling the filter cell to connect the input of the filter cell to the output of the filter cell such that the DC intermediate circuit is bypassed in response to an absolute value of the reference signal of the phase leg of the inverter being within a predetermined range.

2. A method as claimed in claim 1, wherein the reference signal of the phase leg of the inverter is sinusoidal.

3. A method as claimed in claim 1 or 2, wherein the reference signal of the phase leg of the inverter is a voltage reference signal of the phase leg of the inverter.

4. A method as claimed in claim 3, wherein the predetermined range R is defined as: $X ∗ {V}_{Max} \leq R \leq \left(1-X\right) ∗ {V}_{Max} ,$ wherein
V_{Max} is a maximum absolute value for the voltage reference signal of the phase leg of the inverter
X is a selectable variable such that 0<X<0.5.

5. A method as claimed in claim 3, wherein the predetermined range R is defined as: $\left(X+{C}_{pf}\right) ∗ {V}_{Max} \leq R \leq \left(1-X\right) ∗ {V}_{Max} ,$ wherein
V_{Max} is a maximum absolute value for the voltage reference signal of the phase leg of the inverter
C_{pf} is a correction factor for a non-unity power factor
X is a selectable variable such that 0<X<0.5.

6. A method as claimed in claim 3, wherein the predetermined range R is defined as: $X ∗ {V}_{Max} \leq R \leq \left(1-X+{C}_{peak}\right) ∗ {V}_{Max} ,$ wherein
V_{Max} is a maximum absolute value for the voltage reference signal of the phase leg of the inverter
Cₚₑₐₖ is a correction factor for a modulation index
X is a selectable variable such that 0<X<0.5.

7. A method as claimed in claim 3, wherein the predetermined range R is defined as: $\left(X+{C}_{pf}\right) ∗ {V}_{Max} \leq R \leq \left(1-X+{C}_{peak}\right) ∗ {V}_{Max}$ wherein
V_{Max} is a maximum absolute value for the voltage reference signal of the phase leg of the inverter
C_{pf} is a correction factor for a non-unity power factor
Cₚₑₐₖ is a correction factor for a modulation index
X is a selectable variable such that 0<X<0.5.

8. A method as claimed in any one of claims 4 to 7, wherein X is between 0.3 and 0.35, and preferably 1/3.

9. A method as claimed in any one of claims 1 to 8, wherein the method comprises modifying an output voltage from the phase output of the phase leg of the inverter by the filter cell on the basis of the reference signal of the phase leg of the inverter when the absolute value of the reference signal of the phase leg of the inverter is outside the predetermined range.

10. A method as claimed in any one of claims 1 to 9, wherein the filter cell is configured to be controllable to connect the input of the filter cell to the output of the filter cell via the DC intermediate circuit in a first direction of the DC intermediate circuit and to alternatively connect the input of the filter cell to the output of the filter cell via the DC intermediate circuit in a second direction of the DC intermediate circuit, wherein the second direction is opposite to the first direction.

11. A method as claimed in any one of claims 1 to 10, wherein the filter cell comprises at least four controllable semiconductor switches and the DC intermediate circuit, the DC intermediate circuit comprising at least one capacitor.

12. A computer program product comprising program instructions which, when run by a computing apparatus controlling a filter cell coupled to a phase output of a phase leg of an inverter, cause the computing apparatus to carry out a method as claimed in any one of claims 1 to 11.

13. A controller for controlling a filter cell coupled to a phase output of a phase leg of an inverter, the controller configured to carry out a method as claimed in any one of claims 1 to 11.

14. An electric power converter system comprising:
an inverter with at least one phase;
at least one filter cell for each phase of the inverter, an input of the filter cell being coupled to a phase output of a respective phase leg of the inverter, wherein the at least one filter cell comprises a DC intermediate circuit and wherein the at least one filter cell is configured to be controllable to connect the input of the filter cell to an output of the filter cell via the DC intermediate circuit and to alternatively connect the input of the filter cell to the output of the filter cell such that the DC intermediate circuit is bypassed; and
control means configured to control the electric power converter arrangement, the control means comprising a controller as claimed in claim 13.

15. An electric power converter system as claimed in claim 14, wherein the inverter is a three-phase inverter comprising three phase legs.
